(19) **Europäisches Patentamt European Patent Office Office européen des brevets**

(11) **EP 3 067 676 B1**

(12) **FASCICULE DE BREVET EUROPEEN**

(45) Date de publication et mention de la délivrance du brevet:
**16.09.2020 Bulletin 2020/38**

(51) Int Cl.:
**G01J 5/04** (2006.01)          **G01J 5/02** (2006.01)
**G01J 5/20** (2006.01)

(21) Numéro de dépôt: **16156191.5**

(22) Date de dépôt: **17.02.2016**

(54) **DISPOSITIF DE DETECTION DE RAYONNEMENT COMPORTANT UNE STRUCTURE D'ENCAPSULATION A TENUE MECANIQUE AMELIOREE**

**VORRICHTUNG ZUR STRAHLUNGSERFASSUNG, DIE EINE EINKAPSELUNGSSTRUKTUR MIT VERBESSERTER MECHANISCHER FESTIGKEIT UMFASST**

**DEVICE FOR DETECTING RADIATION COMPRISING AN ENCAPSULATION STRUCTURE WITH IMPROVED MECHANICAL STRENGTH**

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **20.02.2015 FR 1551491**

(43) Date de publication de la demande:
**14.09.2016 Bulletin 2016/37**

(73) Titulaire: **Commissariat à l'Énergie Atomique et aux Énergies Alternatives 75015 Paris (FR)**

(72) Inventeurs:
• **DUMONT, Geoffroy**
  **75011 PARIS (FR)**
• **CARLE, Laurent**
  **38000 GRENOBLE (FR)**
• **IMPERINETTI, Pierre**
  **38180 SEYSSINS (FR)**
• **POCAS, Stephane**
  **38000 GRENOBLE (FR)**
• **YON, Jean-Jacques**
  **38360 SASSENAGE (FR)**

(74) Mandataire: **GIE Innovation Competence Group 310, avenue Berthelot 69372 Lyon Cedex 08 (FR)**

(56) Documents cités:
• **GEOFFROY DUMONT ET AL: "Innovative on-chip packaging applied to uncooled IRFPA", OPTICAL SENSING II, vol. 6940, 3 avril 2008 (2008-04-03), page 69401Y, XP055286288, 1000 20th St. Bellingham WA 98225-6705 USA ISSN: 0277-786X, DOI: 10.1117/12.780433 ISBN: 978-1-62841-971-9**
• **Vincent Beix: "Etudes des procédés d'encapsulation hermétique au niveau du substrat par la technologie de transfert de films", , 23 juillet 2014 (2014-07-23), XP055237776, Extrait de l'Internet: URL:https://tel.archives-ouvertes.fr/tel-0 1037897 [extrait le 2015-12-21]**

## Description

### DOMAINE TECHNIQUE

Le domaine de l'invention est celui des dispositifs de détection de rayonnement électromagnétique, en particulier infrarouge ou térahertz, comportant au moins un détecteur thermique, de préférence une matrice de détecteurs thermiques, et une structure d'encapsulation qui forme au moins une cavité hermétique qui loge chacune au moins un détecteur. L'invention s'applique notamment au domaine de l'imagerie infrarouge et de la thermographie.

### ÉTAT DE LA TECHNIQUE ANTÉRIEURE

Un dispositif de détection de rayonnement électromagnétique, par exemple infrarouge ou térahertz, comprend habituellement une matrice de détecteurs thermiques dits élémentaires comportant chacun une portion apte à absorber le rayonnement à détecter. Dans le but d'assurer l'isolation thermique des détecteurs thermiques, chaque portion se présente habituellement sous la forme d'une membrane suspendue au-dessus du substrat et isolée thermiquement de celui-ci par des éléments de maintien et d'isolation thermique. Ces éléments de maintien assurent également une fonction électrique en reliant électriquement les détecteurs thermiques à un circuit de lecture généralement disposé dans le substrat.

Pour assurer un fonctionnement optimal des détecteurs, un faible niveau de pression est requis. Pour cela, les détecteurs sont généralement confinés, ou encapsulés, seuls ou à plusieurs, dans des cavités hermétiques sous vide ou sous pression réduite.

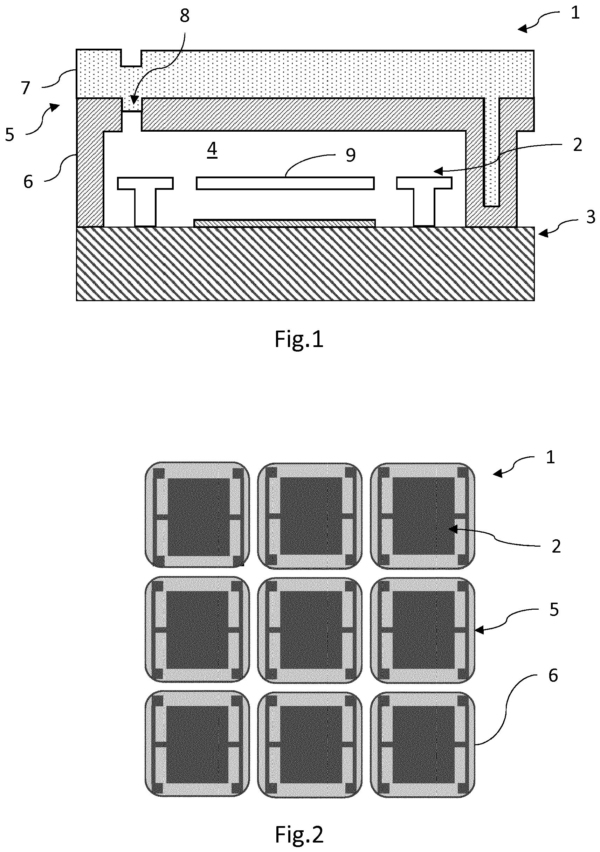

La figure 1 illustre un exemple de dispositif de détection 1 adapté à détecter un rayonnement infrarouge, plus précisément un pixel du dispositif de détection formé ici d'un détecteur bolométrique 2 reposant sur un substrat 3 et disposé seul dans une cavité hermétique 4, tel que décrit dans la publication de Dumont et al, Current progress on pixel level packaging for uncooled IRFPA, Proc. SPIE 8353, Infrared Technology and Applications XXXVIII, 835311 2012.

Dans cet exemple, le dispositif de détection 1 comporte une structure d'encapsulation 5, également appelée capsule, qui définit la cavité 4 dans laquelle se situe le détecteur bolométrique 2. La structure d'encapsulation 5 comporte une couche mince d'encapsulation 6 qui définit avec le substrat 3 la cavité 4, et une couche mince de scellement 7 qui recouvre la couche mince d'encapsulation 6 et assure l'herméticité de la cavité 4. Les couches d'encapsulation 6 et de scellement 7 sont transparentes au rayonnement électromagnétique à détecter.

Le dispositif de détection 1 est réalisé par des techniques de dépôt de couches minces et notamment des couches sacrificielles. Au cours du procédé de réalisation, les couches sacrificielles sont éliminées et évacuées hors de la cavité au travers d'un ou plusieurs évents de libération 8 prévus dans la couche mince d'encapsulation 6. La couche de scellement 7 assure, après élimination des couches sacrificielles et mise sous vide de la cavité 4, le bouchage des évents de libération 8.

Dans le but de maximiser le taux de remplissage (fill factor, en anglais), c'est-à-dire le rapport entre la surface de la membrane absorbante sur la surface totale du pixel, dans le plan du substrat, on souhaite réduire au maximum l'espacement entre les détecteurs et la bordure des capsules, ainsi que l'espacement entre les capsules dans le cas où le dispositif prévoit une pluralité de capsules. Pour cela, la forme optimale des capsules, dans un plan parallèle au plan du substrat, est la forme carrée ou rectangulaire dont les coins sont en angle droit. Cependant, la tenue mécanique des capsules reste à être améliorée. En effet, une défaillance dans la tenue mécanique d'une capsule conduit à la rupture de l'herméticité de la cavité et donc éventuellement à la perte fonctionnelle du détecteur, voire de la matrice de détecteurs.

### EXPOSÉ DE L'INVENTION

L'invention a pour but de remédier au moins en partie aux inconvénients de l'art antérieur, et plus particulièrement de proposer un dispositif de détection de rayonnement électromagnétique, par exemple infrarouge ou térahertz, au moins un détecteur thermique disposé dans une cavité hermétique formée par une structure d'encapsulation, dont la tenue mécanique est renforcée.

L'invention propose à cet effet un dispositif de détection de rayonnement électromagnétique, comprenant un substrat, au moins un détecteur thermique disposé sur le substrat, une structure d'encapsulation du détecteur thermique, comportant une couche mince d'encapsulation s'étendant autour et au-dessus du détecteur thermique de manière à définir avec le substrat une cavité dans laquelle le détecteur thermique est situé, ladite couche mince d'encapsulation étant réalisée en un matériau transparent audit rayonnement électromagnétique.

Selon l'invention, la couche mince d'encapsulation comprend une paroi périphérique qui entoure le détecteur thermique, et qui présente une section, dans un plan parallèle au plan du substrat, de forme carrée ou rectangulaire, dont les coins sont arrondis.

La paroi périphérique comporte une portion arrondie et deux portions rectilignes s'étendant suivant des axes sensiblement orthogonaux l'un à l'autre et reliées l'un à l'autre par la portion arrondie, la portion arrondie présentant un rayon de courbure supérieure ou égal à deux fois l'épaisseur de l'une des portions rectilignes.

Le rayon de courbure de la portion arrondie peut être mesuré à partir de la surface interne, orientée vers la cavité, de la portion arrondie.

La couche mince d'encapsulation peut comporter au moins un orifice traversant, dit évent de libération, ladite structure d'encapsulation comportant en outre une couche de scellement recouvrant la couche mince d'encapsulation de manière à rendre la cavité hermétique, c'est-à-dire que la couche de scellement bouche de manière hermétique l'évent de libération.

Le dispositif peut comporter une matrice de détecteurs disposés dans une même cavité, la couche mince d'encapsulation comprenant en outre au moins une portion, dite portion d'appui interne, située entre deux détecteurs thermiques adjacents, qui prend appui directement sur le substrat.

La portion d'appui interne peut présenter un profil, dans un plan parallèle au plan du substrat, de forme oblongue, de préférence aux extrémités longitudinales arrondies.

La portion d'appui interne peut comporter une paroi latérale et une partie inférieure, ladite paroi latérale s'étendant de manière sensiblement verticale sur toute la hauteur de la cavité et la partie inférieure étant au contact du substrat.

La couche mince d'encapsulation peut comporter au moins un orifice traversant, dit évent de libération, présentant un profil transversal, dans un plan orthogonal au plan du substrat, dont la largeur croît à mesure que la distance au substrat augmente. La structure d'encapsulation peut comporter en outre une couche de scellement recouvrant la couche mince d'encapsulation de manière à rendre la cavité hermétique, la couche de scellement comportant une bordure qui s'étend dans le sens de l'épaisseur de la couche de scellement, à partir de la bordure de l'évent de libération, avec un angle $\alpha$ non nul par rapport à un axe sensiblement orthogonal au plan du substrat, le profil transversal de l'évent de libération formant un angle $\beta$ par rapport au même axe orthogonal supérieur à l'angle a.

Le dispositif de détection peut comporter une matrice de détecteurs thermiques comportant chacun une membrane adaptée à absorber le rayonnement à détecter, suspendue au-dessus du substrat et isolée thermiquement de celui-ci par des clous d'ancrage et des bras d'isolation thermique, la couche mince d'encapsulation comportant une pluralité d'orifices traversants dit évents de libération disposés de sorte qu'au moins une partie desdits détecteurs thermiques ait chacun un unique évent de libération situé en regard de la membrane absorbante correspondante, de préférence au droit du centre de ladite membrane. En d'autres termes, l'unique évent est situé au droit de la membrane absorbante, c'est-à-dire à la perpendiculaire de la membrane absorbante. L'unique évent n'est donc pas situé en regard des clous d'ancrage ni des bras d'isolation thermique. Chaque membrane absorbante peut comporter un orifice traversant, en regard de l'évent de libération correspondant, de dimensions égales ou supérieures à celles dudit évent. En d'autres termes, ladite membrane absorbante, en regard de laquelle est situé un évent de libération, peut comporter un orifice traversant, situé au droit dudit évent de libération, de dimensions égales ou supérieures à celles dudit évent.

La membrane suspendue peut comporter un empilement d'une couche bolométrique, d'une couche diélectrique structurée de manière à former deux portions distinctes, et d'une couche électriquement conductrice structurée de manière à former trois électrodes, dont deux électrodes destinées à être portées à une même potentiel électrique encadrent la troisième électrode dite centrale destinée à être portée à un potentiel électrique différent, chaque électrode étant au contact de la couche bolométrique, l'électrode centrale étant électriquement isolée des autres électrodes par la couche diélectrique, l'orifice traversant l'électrode centrale et la couche bolométrique dans une zone située entre les portions de la couche diélectrique.

La structure d'encapsulation peut comporter en outre une couche de scellement recouvrant la couche mince d'encapsulation de manière à rendre la cavité hermétique, le substrat comprenant une couche d'accroche disposée en regard de l'orifice traversant de la membrane correspondante, et adaptée à assurer l'adhésion du matériau de la couche de scellement.

La couche d'accroche peut s'étendre sous l'ensemble de la membrane correspondante et être réalisée en un matériau adapté pour assurer en outre la réflexion du rayonnement électromagnétique à détecter.

L'invention porte également sur un procédé de réalisation d'un dispositif de détection selon l'une quelconque des caractéristiques ci-dessus, dans lequel la couche mince d'encapsulation est déposée sur une couche sacrificielle, cette dernière étant ensuite supprimée et évacuée au travers d'au moins un évent de libération de la couche mince d'encapsulation.

## BRÈVE DESCRIPTION DES DESSINS

D'autres aspects, buts, avantages et caractéristiques de l'invention apparaîtront mieux à la lecture de la description détaillée suivante de formes de réalisation préférées de celle-ci, donnée à titre d'exemple non limitatif, et faite en référence aux dessins annexés sur lesquels :

- la figure 1, précédemment décrite en référence à un exemple de l'art antérieur, est une vue schématique en coupe d'un dispositif de détection selon un mode de réalisation ;

- la figure 2 est une représentation schématique, en vue de dessus, d'un dispositif de détection selon un mode de réalisation, présentant une matrice de détecteurs où chaque détecteur est logé dans une cavité distincte, les cavités présentant une forme aux coins arrondis ;

- la figure 3 est une représentation partielle et schématique, en vue de dessus, de la paroi périphérique de la couche mince d'encapsulation selon un mode de réalisation, où la paroi comporte, au niveau des coins de la cavité, une portion arrondie ;

- la figure 4 est une représentation partielle et schématique, en vue de dessus, de la paroi périphérique de la couche mince d'encapsulation selon un exemple ne tombant pas dans le champ de l'invention ;
- la figure 5 est une représentation schématique, en vue de dessus, d'un dispositif de détection selon un mode de réalisation, où une matrice de détecteurs est logée dans une même cavité ;
- la figure 6 est une vue schématique en coupe selon le plan A-A du dispositif de détection représenté sur la figure 5 ;
- la figure 7 est une vue schématique en coupe selon le plan B-B du dispositif de détection représenté sur la figure 5 ;
- les figures 8 à 10 sont des vues schématiques en coupe d'un dispositif de détection selon un mode de réalisation, à différentes étapes du procédé de réalisation ;
- la fig. 11 est une représentation schématique en vue de dessus d'un évent de libération selon un autre mode de réalisation, dans lequel l'évent présente un profil de forme oblongue à extrémités arrondies ;
- la figure 12 est une vue partielle en coupe d'une partie d'un dispositif de détection selon un mode de réalisation ;
- la figure 13 est une vue schématique en coupe d'un dispositif de détection selon un mode de réalisation, dans lequel un unique évent d'évacuation par détecteur, disposé en regard de la membrane suspendue, et où la membrane comporte un orifice traversant situé au droit de l'évent d'évacuation ;
- les figures 14 et 15 sont des vues schématiques d'un dispositif de détection selon un autre mode de réalisation, dans lequel la membrane suspendue comporte une couche diélectrique intermédiaire.

## EXPOSÉ DÉTAILLÉ DE MODES DE RÉALISATION PARTICULIERS

Sur les figures et dans la suite de la description, les mêmes références représentent les éléments identiques ou similaires.

La figure 1, décrite précédemment en partie en référence à un exemple de l'art antérieur, illustre ici un exemple de dispositif de détection de rayonnement électromagnétique selon un mode de réalisation.

Dans cet exemple, le dispositif de détection 1 de rayonnement électromagnétique est adapté à détecter un rayonnement infrarouge ou térahertz. Il comporte une matrice de détecteurs thermiques 2, dits élémentaires. La figure 1 est une vue partielle du dispositif de détection et ne représente qu'un seul détecteur disposé dans une cavité.

Il comprend un substrat 3, par exemple en silicium, comprenant un circuit de lecture (non représenté) par exemple réalisé en technologie CMOS, permettant d'appliquer les polarisations nécessaires au fonctionnement des détecteurs et de lire les informations issues de ceux-ci.

Le détecteur thermique 2 comprend une portion adaptée à absorber le rayonnement à détecter. Cette portion absorbante est généralement isolée thermiquement du substrat et peut être disposée au niveau d'une membrane 9, dite absorbante, suspendue au-dessus du substrat 3 par des éléments de maintien et d'isolation thermique 11 tels que des clous d'ancrage 11a associés à des bras d'isolation thermique 11b. La membrane 9 est espacée du substrat 3 d'une distance typiquement comprise entre 1$\mu$m et 5$\mu$m, de préférence 2$\mu$m quand le détecteur est conçu pour la détection d'un rayonnement infrarouge dont la longueur d'onde est comprise entre 8$\mu$m et 14$\mu$m.

Dans la suite de la description, les détecteurs thermiques 2 sont des bolomètres dont la membrane absorbante 9 comporte un matériau thermistance dont la conductivité électrique varie en fonction de l'échauffement de la membrane. Cependant, cet exemple est donné à titre illustratif et est nullement limitatif. Tout autre type de détecteur thermique peut être utilisé, par exemple des détecteurs pyroélectriques, ferroélectriques, voire des thermopiles.

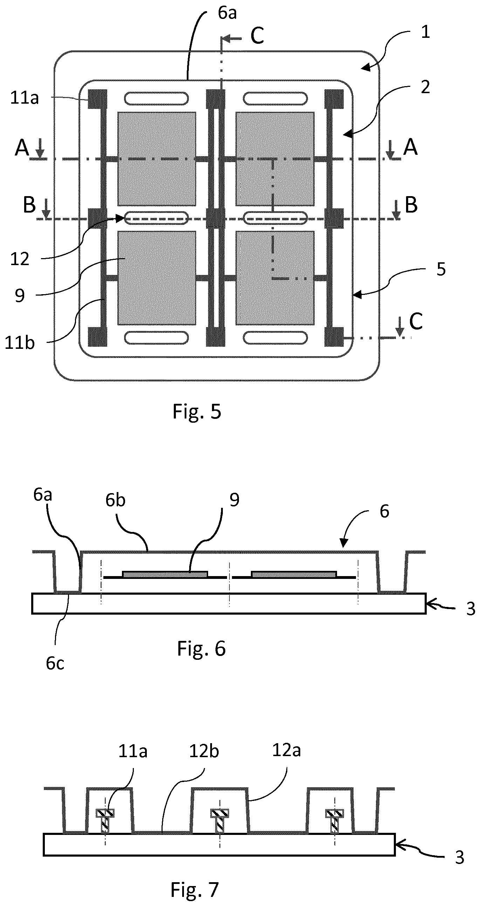

Dans un exemple détaillé par la suite en référence à la figure 5, les détecteurs 2, disposés dans une même cavité, peuvent être rapprochés les uns des autres, notamment en reliant les bras d'isolation thermique 11b de différents détecteurs thermiques à un même clou d'ancrage 11a, l'architecture de lecture des détecteurs thermiques étant alors adaptée, comme le décrivent les documents EP1106980 et EP1359400. Il en résulte une amélioration de la sensibilité des détecteurs 2 de par l'allongement des bras d'isolation 11b et une augmentation du taux de remplissage par la réduction de la surface de chaque pixel non dédiée à l'absorption du rayonnement électromagnétique. Le dispositif de détection est ainsi particulièrement adapté aux petits pas de matriçage, par exemple entre 25$\mu$m et 17$\mu$m, voire 12$\mu$m.

Le dispositif de détection 1 comporte une structure d'encapsulation 5, ou capsule, qui définit, avec le substrat 3, une cavité hermétique 4 à l'intérieur de laquelle se trouve le détecteur thermique 2. La structure d'encapsulation 5 est formée d'une couche mince d'encapsulation 6 déposée de sorte qu'elle comporte une paroi périphérique 6a qui entoure le détecteur 2 et une paroi supérieure 6b qui s'étend au-dessus du détecteur 2. La paroi supérieure 6b est sensiblement plane et s'étend au-dessus de la membrane suspendue 9 à une distance par exemple comprise entre 0,5$\mu$m et 5$\mu$m, de préférence 1,5$\mu$m.

La couche d'encapsulation 6 est une couche mince au sens où elle présente une épaisseur inférieure à quelques dizaines de microns, par exemple à 10$\mu$m, et qu'elle est réalisée par des techniques classiques de dépôt de couches de la microélectronique, notamment des techniques de dépôt conforme, telles que la CVD (*Chemical Vapor Deposition,* en anglais) ou l'iPVD (*Io-*

*nized Physical Vapor Deposition).*

Par ailleurs, la couche d'encapsulation 6 est réalisée en un matériau transparent au rayonnement électromagnétique à détecter. Par matériau transparent, on entend un matériau dont le taux de transmission du rayonnement à détecter est supérieur à 20%, de préférence à 50%, de préférence à 80%, et de préférence encore à 90%. Dans le cas du rayonnement infrarouge, par exemple dans la gamme de longueur d'onde comprise entre $8\mu m$ et $14\mu m$, un exemple de matériau transparent est le silicium, par exemple le silicium amorphe, dont le taux de transmission est ici supérieur à 95%. A titre purement illustratif, il peut également s'agir du germanium ou de l'alliage silicium-germanium.

Comme décrit plus loin, la couche d'encapsulation 6 est de préférence réalisé par une technique de couche mince libérée, dans le sens où elle est déposée sur une couche sacrificielle qui recouvre le détecteur, cette dernière étant ensuite supprimée et évacuée au travers d'au moins un orifice traversant de la couche d'encapsulation dit évent de libération. Cette technique de réalisation se distingue notamment des techniques dites de couche mince transférée, dans lesquelles la couche mince d'encapsulation est réalisée sur un substrat structuré distinct du substrat 3, puis est reportée et assemblée au substrat 3.

La figure 2 est une représentation schématique, en vue de dessus, d'une matrice de détecteurs 2 où chaque détecteur est disposé dans une cavité hermétique distincte des voisines. La couche mince d'encapsulation 6 est déposée de manière à s'étendre autour et au-dessus de chaque détecteur. Ainsi, une pluralité de capsules 5 est formée. Chaque capsule présente ici une section, dans un plan parallèle au plan du substrat, de forme carrée ou rectangulaire aux coins arrondis.

Les inventeurs ont observé que la réalisation de portions arrondies au niveau des coins de la capsule améliore l'adhérence de celle-ci sur le substrat. Il a en effet été observé que l'adhérence de la capsule n'est pas homogène le long de la paroi périphérique et que les coins de la capsule présentent une adhérence renforcée lorsque des portions arrondies sont réalisées.

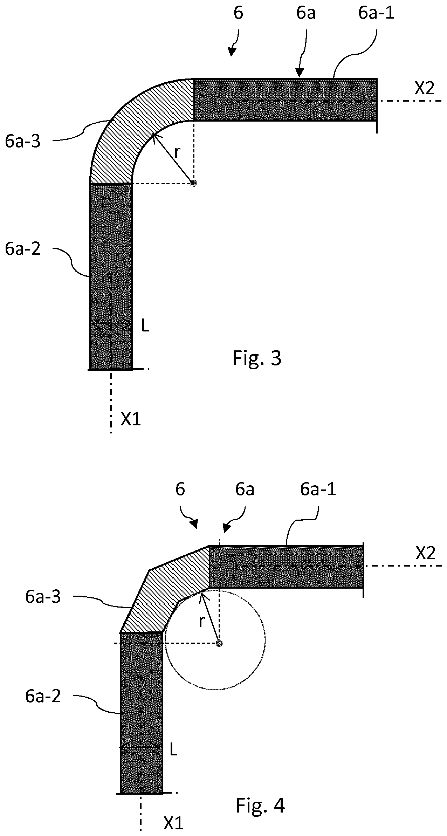

Comme le montre la figure 3, la paroi périphérique 6a de la couche mince d'encapsulation 6 est formée, au niveau de chaque coin de la capsule, de deux portions 6a-1, 6a-2 s'étendant de manière sensiblement rectiligne, suivant chacune un axe X1, X2 sensiblement orthogonal l'un à l'autre. Les portions rectilignes 6a-1 et 6a-2 ne se rejoignent pas suivant un angle droit mais sont reliées l'une à l'autre par une portion arrondie 6a-3. Par portion arrondie, on entend une portion présentant au moins un segment courbe, par exemple circulaire ou elliptique.

La figure 3 présente un exemple de portion arrondie 6a-3 sous forme d'un segment en arc de cercle reliant les portions rectilignes 6a-1 et 6a-2. Le rayon de cet arc de cercle, mesuré à partir de la surface externe de la portion arrondie 6a-3, c'est-à-dire orientée vers l'extérieur de la cavité (cercle exinscrit), est supérieur ou égal à deux fois la largeur L de la paroi périphérique. De préférence, la dimension de la portion arrondie est telle que le rayon d'un cercle inscrit, c'est-à-dire tangent à la surface interne, orientée vers la cavité, de la portion arrondie est supérieur ou égal à deux fois la largeur L.

La largeur L est définie comme la largeur moyenne d'une portion sensiblement rectiligne 6a-1, 6a-2 de la paroi périphérique 6a. La portion arrondie 6a-3 présente de préférence une largeur sensiblement égale à celle des portions rectilignes.

La figure 4 présente un autre exemple, qui ne tombe pas dans le champ de l'invention. Dans cet exemple, la portion arrondie 6a-3 est formée par la succession de deux segments droits inclinés l'un vis-à-vis de l'autre. On peut définir un cercle exinscrit, tangent à la surface externe de chaque segment. L'orientation des segments peut être telle que le rayon du cercle exinscrit est supérieur ou égal à deux fois la largeur L de la paroi périphérique. De préférence, l'orientation des segments est telle que le rayon d'un cercle inscrit, c'est-à-dire tangent à la surface interne des segments, est supérieur ou égal à deux fois la largeur L.

A titre d'exemple, la largeur L de la paroi périphérique de la couche mince d'encapsulation peut être comprise entre 200nm et $2\mu m$ environ. Le rayon du cercle exinscrit ou inscrit est supérieur ou égal à une valeur comprise entre 400nm et $4\mu m$ en fonction de la largeur L, par exemple $2\mu m$ dans le cas d'une largeur L égale à 800nm.

Selon un mode de réalisation représenté sur les figures 5 à 7, le dispositif de détection comporte une matrice de détecteurs 2 qui loge dans une même cavité hermétique, aux coins arrondis. La structure d'encapsulation 5 comporte au moins une portion d'appui interne 12 située entre deux détecteurs adjacents 2, et de préférence une pluralité de portions d'appui interne. Certaines portions d'appui interne peuvent en outre être disposées en périphérie de la matrice de détecteurs 2, en bordure de la cavité 4. Les portions d'appui interne 12 sont formées par la couche mince d'encapsulation 6, qui comporte ainsi de manière continue la paroi périphérique 6a, la paroi supérieure 6b et les portions d'appui interne 12.

Les portions d'appui interne 12 reposent, ou prennent appui, directement sur le substrat 3. En d'autres termes, elles sont en contact direct avec le substrat. Ces portions d'appui interne 12 permettent ainsi de renforcer la tenue mécanique de la capsule 5. L'adhérence de la capsule 5 sur le substrat 3 est ainsi assurée d'une part par une partie inférieure de la paroi périphérique 6a de la couche mince d'encapsulation 6 qui repose sur le substrat en périphérie de la cavité, et d'autre part par la ou les portions d'appui interne 12 disposée(s) dans la cavité.

Cette multiplicité de surfaces de contact, réparties en bordure de la cavité et à l'intérieur de celle-ci, permet de renforcer la tenue mécanique de la capsule. De plus, dans la mesure où la capsule comporte en plus des coins arrondis, l'adhérence globale de la capsule sur le substrat est particulièrement renforcée, de par un effet synergique entre la multiplicité des surfaces d'appui disposées dans la cavité et le renfort localisé de l'adhérence aux coins de la cavité.

Par repose directement sur, ou prennent appui directement sur le substrat, on entend que les portions d'appui interne 12 est en contact directement avec le substrat 3, que ce soit avec le matériau constitutif du substrat ou avec une couche mince déposée sur la surface du substrat, par exemple une couche de passivation ou une couche d'accroche, que ces couches minces s'étendent de manière continue ou non. Les portions d'appui interne ne reposent donc pas sur le substrat par l'intermédiaire d'éléments tridimensionnels tels que les éléments de maintien des membranes suspendues.

Les inventeurs ont en effet constaté que, lorsque des portions d'appui de la couche mince d'encapsulation reposent, non pas sur le substrat, mais sur les éléments de maintien des membranes suspendues, plus précisément sur les clous d'ancrage, des problèmes d'adhérence de la capsule sur le substrat apparaissent, qui peuvent conduire à un décollement voire à la destruction de la capsule. Il semble en effet que les clous d'ancrage offrent une surface de contact et une planéité insuffisantes pour assurer une bonne adhérence des portions d'appui de la couche mince d'encapsulation. Le dispositif de détection selon l'invention réduit ainsi les risques de décollement de la capsule liés aux contraintes mécaniques qui siègent dans les couches minces de la capsule, qu'il s'agisse des contraintes intrinsèques desdites couches minces ou des contraintes extrinsèques résultant de la dilatation thermique différentielle de la capsule relativement au substrat.

Ainsi, la structure d'encapsulation 5 définit une cavité hermétique 4 qui loge la matrice de détecteurs thermiques 2, cette cavité 4 présentant une forme de réseau de sous-cavités, ou alvéoles, communicantes entre elles, qui logent chacune un sous-ensemble de détecteurs thermiques. Les alvéoles sont séparées les unes des autres par les portions d'appui interne. Comme expliqué précédemment, ce réseau d'alvéoles est délimité par la même couche mince d'encapsulation 6 qui s'étend de manière continue de manière à former les parois périphérique 6a et supérieure 6b de la cavité 4 ainsi que les portions d'appui interne 12.

Ainsi, le dispositif de détection de rayonnement 1 comporte une cavité hermétique 4 qui loge une pluralité de détecteurs thermiques 2 tout en présentant une tenue mécanique de cavité renforcée par la présence de la ou des portions d'appui interne 12 qui reposent directement sur le substrat 3. Le fait de loger une pluralité de détecteurs thermiques 2 dans la cavité autorise l'augmentation du taux de remplissage, par exemple en diminuant le pas de matriçage ou en agrandissant les membranes absorbantes 9, voire en mutualisant les clous d'ancrage 11a. Par ailleurs, le couplage électrique parasite entre détecteurs 2 est évité dans la mesure où les portions d'appui interne 12 ne sont pas en contact des clous d'ancrage. Ce dispositif autorise en outre l'allongement des bras d'isolation thermique 11b pour améliorer l'isolation thermique des membranes absorbantes 9.

La figure 6 est une vue en coupe selon le plan A-A du dispositif de détection 1 représenté sur la figure 5. Elle montre plus en détail la couche mince d'encapsulation 6 s'étendant de manière continue autour et au-dessus de la matrice de détecteurs 2 de manière à former la cavité 4. La paroi périphérique 6a forme la bordure de la cavité et la paroi supérieure 6b s'étend au-dessus des détecteurs 2. La paroi périphérique 6a présente une partie inférieure 6c périphérique qui est en appui, ou repose, directement sur le substrat, de manière à assurer l'adhésion de la capsule sur le substrat.

La figure 7 est une vue en coupe selon le plan B-B du dispositif de détection 1 représenté sur la figure 3. Sur cette figure, les portions d'appui interne 12 présentent chacune une paroi latérale périphérique 12a et une partie inférieure 12b, et prennent appui directement sur le substrat 3 au niveau de la paroi inférieure 12b. En d'autres termes, chaque portion d'appui interne 12 est en contact directement avec le substrat 3, que ce soit avec le matériau constitutif du substrat 3 ou, comme mentionné précédemment, avec une couche mince déposée à la surface du substrat.

Comme représenté sur la figure 5, les portions d'appui interne 12 peuvent présenter un profil, dans le plan du substrat, de forme oblongue, c'est-à-dire allongée. Elles peuvent être disposées chacune entre deux membranes suspendues adjacentes et deux clous d'ancrage voisins, de manière à optimiser le taux de remplissage. Les extrémités du profil oblong des portions d'appui interne 12 peuvent être arrondies, de manière à renforcer l'adhérence de celles-ci sur le substrat 3 par une meilleure répartition des contraintes mécaniques. La largeur des portions d'appui interne peut être inférieure à $1,5\mu m$, par exemple comprise entre $0,5\mu m$ et $0,8\mu m$, et la longueur peut être ajustée en fonction de l'espace disponible entre les détecteurs et notamment les clous d'ancrage.

Dans l'exemple de la figure 5, les bras d'isolation thermique 11b s'étendent principalement suivant un premier axe perpendiculaire ici au plan de coupe B-B, et les portions d'appui interne 12 de la capsule 5 s'étendent suivant un second axe orthogonal au premier axe, ici colinéaire au plan de coupe A-A, entre deux membranes 9 adjacentes et deux clous d'ancrage 11a voisins. La largeur et la longueur des portions d'appui interne peuvent être optimisées en bénéficiant de la surface laissée libre dans cette zone par l'absence de bras d'isolation thermique. La surface des portions d'appui interne en contact avec le substrat peut ainsi être importante, ce qui améliore l'adhérence et la tenue mécanique de la capsule.

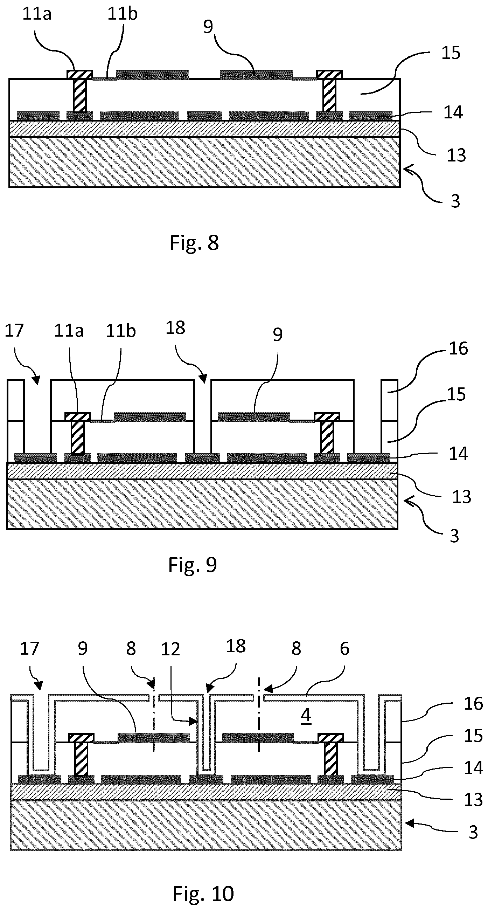

Un exemple de procédé de réalisation est maintenant détaillé, en référence aux figures 8 à 10 qui sont des vues, en coupe selon l'axe C-C, du dispositif de détection représenté sur la figure 5.

Le dispositif de détection 1 comprend un substrat 3 dans lequel est prévu un circuit de lecture et de commande des détecteurs thermiques 2. Le substrat 3 peut comprendre une couche de passivation 13, par exemple en oxyde de silicium SiO ou nitrure de silicium SiN. Selon un mode de réalisation détaillé par la suite, le substrat 3 peut également comprendre une couche d'accroche 14, continue ou non, déposée sur la couche de passivation 13. La couche d'accroche 14 peut être réalisée en titane ou en chrome, et présenter une épaisseur par exemple comprise environ entre 100nm et 300nm.

De manière connue en soi, on dépose une première couche sacrificielle 15 et on réalise les clous d'ancrage 11a, les bras d'isolation thermique 11b et les membranes absorbantes 9 dans et sur cette couche sacrificielle 15. La couche sacrificielle peut être réalisée en polyimide voire en un matériau minéral tel que de l'oxyde de silicium, du polysilicium ou du silicium amorphe.

Comme l'illustre la figure 9, une deuxième couche sacrificielle 16 est ensuite déposée sur la première couche sacrificielle 15, les éléments d'ancrage 11a et d'isolation thermique 11b et les membranes absorbantes 9. Elle est de préférence réalisée dans le même matériau que celui de la première couche sacrificielle 15 et présente une épaisseur par exemple comprise entre $0,5\mu m$ et $5\mu m$.

Des étapes de photolithographie et de gravure, par exemple de gravure RIE, sont réalisées de manière à former, de préférence au cours d'une séquence d'étapes communes, des tranchées 17, 18 au travers de toute l'épaisseur des couches sacrificielles, c'est-à-dire jusqu'au substrat 3, plus précisément ici jusqu'à la couche d'accroche 14. Une première tranchée 17 est réalisée de manière à s'étendre de manière continue autour de la matrice de détecteurs 2 et est destinée à la réalisation ultérieure de la paroi périphérique de la structure d'encapsulation. La tranchée 17 est réalisée de manière à ce que la forme finale de la capsule, dans un plan parallèle au plan du substrat, présente une forme carrée ou rectangulaire aux coins arrondis.

Au moins une seconde tranchée 18, et de préférence plusieurs, est réalisée entre deux détecteurs adjacents 2 dans le but de former par la suite la portion d'appui interne. Les premières et secondes tranchées 17, 18 présentent une profondeur sensiblement identique, de sorte que la paroi périphérique de la structure d'encapsulation et les parois latérales des portions d'appui présentent in fine une hauteur sensiblement identique. Le procédé est ainsi simplifié, notamment en ce qui concerne le contrôle de la profondeur de gravure.

Dans le cas où les couches sacrificielles 15, 16 sont en polyimide, le procédé de réalisation des tranchées peut impliquer le dépôt d'une couche de protection minérale (non représentée), par exemple en SiN ou en SiO, ou encore en silicium amorphe, sur la surface de la deuxième couche sacrificielle 16. Une étape de photolithographie permet alors de définir des ouvertures dans une couche de résine aux endroits où il est prévu de graver les tranchées. La gravure des tranchées est ensuite réalisée en 2 étapes, une première étape au cours de laquelle la couche de protection est gravée, par exemple par gravure RIE, au droit des ouvertures de la résine, une deuxième étape au cours de laquelle la première et la deuxième couche sacrificielle sont gravées, par exemple par gravure RIE, jusqu'au substrat au droit des ouvertures obtenues dans la couche de protection à la première étape de gravure. A ce stade, la couche de protection peut être supprimée.

Cet enchaînement d'étapes est justifié par des contraintes de compatibilité chimique des couches en présence et par des contraintes géométriques (facteur de forme des tranchées). En effet, la couche de résine disparait au cours de la deuxième étape de gravure du polyimide car ces couches sont toutes de nature organique, par conséquent similairement sensibles à la chimie de gravure mise en œuvre à la deuxième étape. L'ouverture de la couche de protection est alors utilisée comme relais pour continuer à limiter la gravure aux zones où l'on souhaite réaliser les tranchées. Le procédé de la deuxième étape de gravure est par ailleurs adapté pour garantir une grande anisotropie de gravure, ce qui permet d'obtenir des facteurs de forme élevés et des flancs de gravure verticaux (orthogonaux au plan du substrat) sans présence de surplomb. Il est en outre adapté pour garantir une sélectivité élevée d'une part vis-à-vis de la couche de protection (en SiN ou SiO) et d'autre part vis-à-vis de la surface du substrat, généralement recouverte d'une couche de passivation isolante en SiO ou SiN. Cette sélectivité élevée est avantageuse car elle permet de réduire l'épaisseur de la couche de protection (typiquement à 30 nm), ce qui est de nature à faciliter son élimination ultérieure.

Les tranchées 17, 18, notamment les secondes tranchées 18 destinées à la réalisation des portions d'appui interne, présentent un rapport de forme élevé. A titre d'exemple, des tranchées de largeur inférieure ou égale à $1,5\mu m$, par exemple comprise entre $0,5nm$ et $0,8\mu m$ peuvent être réalisées dans une couche de polyimide d'épaisseur comprise entre $2\mu m$ et $6\mu m$, par exemple $4\mu m$. La longueur des secondes tranchées 18 peut être adaptée en fonction des contraintes d'intégration compacte et de robustesse de la capsule, et peut être de l'ordre de quelques microns à quelques millimètres. Ces dimensions des tranchées permettent de réaliser une matrice de détecteurs thermiques à un pas de matriçage particulièrement faible, par exemple $17\mu m$ voire $12\mu m$.

La couche d'accroche 14 est de préférence réalisée en un matériau vis-à-vis duquel la gravure des tranchées est sélective, de manière à éviter toute gravure du substrat. Le matériau peut être du titane, du chrome et la couche d'accroche peut présenter une épaisseur de l'ordre de 100nm à 300nm.

Comme le montre la figure 10, une couche mince d'encapsulation 6, transparente au rayonnement à détecter, est ensuite déposée selon une technique de dépôt conforme adaptée pour obtenir un bon recouvrement des flancs verticaux des tranchées 17, 18, avec une épaisseur de couche sensiblement constante. Il peut s'agir par exemple d'une couche de silicium amorphe élaboré par CVD ou par iPVD, d'une épaisseur typiquement comprise entre environ 200nm et 2000nm lorsqu'elle est mesurée sur une surface plane. Du germanium Ge ou un alliage de silicium-germanium SiGe peut également convenir. Le dépôt de la couche mince d'encapsulation 6 sur une surface structurée par des tranchées dont au moins une tranchée périphérique 17 continue (périmètre fermé de forme carrée ou rectangulaire, aux coins arrondis) conduit à la formation de la capsule 5, réalisée avec le matériau de la couche mince d'encapsulation et formant, en contact avec le substrat 3, une cavité 4 dans laquelle est logée la matrice de détecteurs. Le recouvrement des flancs des tranchées internes 18 par la couche mince d'encapsulation 6 permet de reproduire la forme des tranchées internes pour former des portions d'appui interne 12, de préférence de forme oblongue avec des extrémités arrondies. Notons que ces portions d'appui interne 12 peuvent être pleines ou creuses (constituées de deux parois espacées) selon que la largeur des tranchées internes 18 est respectivement petite ou grande devant l'épaisseur de la couche mince d'encapsulation 6.

Des orifices traversants, formant des évents de libération 8 destinés à permettre l'évacuation des couches sacrificielles 15, 16 hors de la cavité 4, sont ensuite réalisés par photolithographie et gravure dans la couche mince d'encapsulation 6. Chaque évent 8 peut être de forme carrée, rectangulaire, circulaire, voire oblongue.

On élimine ensuite les couches sacrificielles 15, 16 par attaque chimique, préférentiellement en phase gazeuse ou en phase vapeur selon la nature des couches sacrificielles (phase gazeuse dans le cas du polyimide décrit ici), de manière à former la cavité 4 logeant la matrice de détecteurs 2, et les portions d'appui interne 12.

Une couche de scellement (non représentée sur la figure 10) est ensuite déposée sur la couche mince d'encapsulation 6 avec une épaisseur suffisante pour assurer le scellement, ou bouchage, des évents de libération 8. La couche de scellement est transparente au rayonnement électromagnétique à détecter et peut présenter une fonction d'antireflet pour optimiser la transmission du rayonnement au travers de la structure d'encapsulation. A ce titre, elle peut être formée de sous-couches de germanium et de sulfure de zinc dans le cas d'un rayonnement à détecter dans la gamme des longueurs d'onde allant de $8\mu m$ à $12\mu m$, par exemple une première sous-couche de germanium de $1,7\mu m$ environ puis une deuxième sous-couche de sulfure de zinc de $1,2\mu m$ environ. La couche de scellement est de préférence déposée par une technique de dépôt de couches minces sous vide, comme l'évaporation sous vide d'une source chauffée par faisceau d'électrons (EBPVD) ou comme la pulvérisation cathodique ou par faisceau d'ions. On obtient ainsi une cavité hermétique 4 sous vide ou pression réduite dans laquelle est logée la matrice de détecteurs thermiques 2.

Selon un autre mode de réalisation non représenté, qui se différencie de l'exemple de la figure 5 où une seule portion d'appui interne 12 est réalisée entre deux détecteurs 2 adjacents, par le fait que plusieurs portions d'appui interne, ici deux portions d'appui interne de profil oblong, s'étendent longitudinalement suivant le même axe, et sont situées entre deux détecteurs 2 adjacents. Comme dans l'exemple de la figure 5, l'axe longitudinal des portions d'appui interne 12 peut être sensiblement perpendiculaire à l'axe suivant lequel s'étendent principalement les bras d'isolation 11b. L'augmentation du nombre de portions d'appui interne 12 permet de renforcer l'adhérence de la capsule 5 sur le substrat 3 et ainsi de renforcer la tenue mécanique de celle-ci.

Selon un autre mode de réalisation non représenté, chaque détecteur 2 peut être relié à quatre clous d'ancrage 11a dont certains sont communs à deux détecteurs directement voisins situés sur la même colonne (ou sur la même ligne). Cette architecture permet à la fois d'améliorer la tenue mécanique des membranes suspendue 9 et autorise une lecture séquentielle ligne après ligne (respectivement colonne après colonne) de la matrice des détecteurs comme il est habituel de le faire en utilisant des moyens de lecture localisés en bout de colonne (respectivement en bout de ligne) dans un circuit de lecture réalisé dans le substrat du dispositif. Cette architecture à clous d'ancrage partagés offre une amélioration de la sensibilité des détecteurs car les bras d'isolation thermique 11b peuvent être allongés et le taux de remplissage est amélioré par la mutualisation des points d'ancrage 11a qui ne contribuent pas à capter le signal infrarouge.

Dans cet exemple, les portions d'appui interne 12 de la capsule 5 sont préférentiellement positionnées au pas de répétition des détecteurs, dans les deux dimensions de la matrice des détecteurs. La forme des portions d'appui 12 est essentiellement linéaire et ceux qui sont colinéaires aux bras d'isolation 11b sont avantageusement agencés entre les bras des détecteurs 2 d'une même ligne. Le positionnement des portions d'appui selon deux axes est de nature à renforcer l'adhérence de la capsule sur le substrat.

Avantageusement, des portions d'appui interne 12 peuvent également être réalisées entre les détecteurs de bord et la paroi périphérique 6a de la capsule 5. Ces portions d'appui supplémentaires ont essentiellement pour fonction de restituer, pour les détecteurs de bord, un environnement (notamment d'un point de vue optique) comparable à celui des détecteurs de cœur. Une autre possibilité pour réduire ces effets de bord serait de prévoir, en périphérie de matrice, des couronnes de détecteurs postiches, ne contribuant pas au signal vidéo du dispositif matriciel. Des couronnes de un à quelques détecteurs, typiquement deux, remplissent cette fonction de manière satisfaisante.

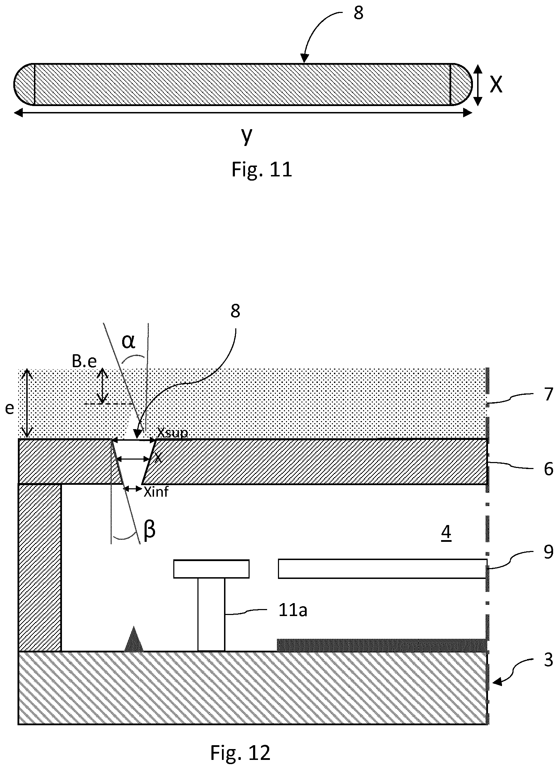

Selon un mode de réalisation représenté sur la figure 11, le profil des évents de libération 8, dans un plan parallèle au plan du substrat, présente une forme oblongue, c'est-à-dire allongée. Sa petite dimension X, mesurée dans le sens de la largeur de l'évent, est choisie de manière à assurer un scellement efficace de l'évent, et sa grande dimension Y, mesurée dans le sens de la longueur de l'évent, peut être ajustée pour faciliter le transit des espèces réactives et des produits de réaction de la gravure du matériau des couches sacrificielles 15, 16 en cours d'élimination, ce qui permet d'optimiser le temps d'évacuation des couches sacrificielles. A ce titre, la largeur X peut être typiquement comprise entre environ 150nm et 600nm, alors que la grande dimension Y peut être de l'ordre de quelques microns, par exemple 5μm.

De manière avantageuse, les évents 8 présentent une forme oblongue aux extrémités longitudinales arrondies. A titre d'exemple, la forme arrondie d'une extrémité peut présenter un rayon de courbure égal à la moitié de la largeur X de l'évent. Plus généralement, elle peut correspondre à une forme courbe continue, comme dans l'exemple de la figure 11, circulaire ou elliptique, ou à une succession de segments droits ou sensiblement courbes. Les inventeurs ont montré que cette forme d'évent permet d'éviter les risques de formation de fissures partant de la couche mince d'encapsulation 6 et se propageant dans la couche de scellement 7. Il est en effet essentiel d'éviter tout risque de fissures susceptibles de rompre l'herméticité de la cavité, dans la mesure où un défaut local d'herméticité pourrait conduire à la perte fonctionnelle du dispositif complet.

Comme le montre la figure 12, les inventeurs ont observé que la couche de scellement 7, en bordure des évents 8, a tendance à s'étendre verticalement, c'est-à-dire dans le sens de l'épaisseur de la couche 7, avec un angle $\alpha$ non nul par rapport à la normale, c'est-à-dire par rapport à un axe orthogonal au plan du substrat, en particulier lorsqu'une technique de dépôt de couche mince sous vide, telle que l'évaporation ou la pulvérisation à basse pression, est utilisée. La largeur moyenne X des évents peut être choisie en fonction de l'épaisseur e de la couche de scellement 7 déposée, de la fraction d'épaisseur B de la couche de scellement assurant effectivement l'herméticité, et de l'angle de croissance a, à partir de la relation :

$$X = 2.e.(1-B).\tan(\alpha)$$

A titre d'exemple, pour une technique de dépôt de la couche de scellement par évaporation, l'angle $\alpha$ est typiquement de l'ordre de 15° à 20°. Pour une épaisseur e de couche de scellement de 1800nm et si l'on souhaite que 1200nm de couche assure l'herméticité (B=2/3), on obtient une largeur moyenne X de l'évent de l'ordre de 320nm à 410nm.

Par ailleurs, il est avantageux que l'évent de libération 8 ait une section transversale, dans un plan orthogonal à celui du substrat, qui présente une forme dont l'ouverture s'élargit à mesure qu'on s'éloigne du substrat 3. En d'autres termes, l'évent 8 a un profil transversal évasé vers l'extérieur de la cavité. Il est plus étroit au niveau de son orifice inférieur débouchant sur la cavité et plus large au niveau de son orifice supérieur débouchant hors de la cavité. A titre d'exemple, la largeur $X_{inf}$ au niveau de l'orifice inférieur peut être de l'ordre de 100nm à 350nm alors que la largeur $X_{sup}$ au niveau de l'orifice supérieur peut être de l'ordre de 250nm à 800nm. Dans cet exemple, la couche mince d'encapsulation 6 présente une épaisseur de l'ordre de 800nm. Il résulte de cette forme de la section transversale de l'évent 8 qu'elle permet d'améliorer la qualité de scellement de l'évent. Plus précisément, pour une même épaisseur e de couche de scellement, les inventeurs ont observé que la fraction B de couche qui assure effectivement le scellement est supérieure au cas où l'évent présenterait une section transversale droite, ce qui améliore la qualité de scellement.

Une telle section transversale de l'évent peut être obtenue en générant une pente sur les flancs de la résine avant gravure de l'évent soit par fluage post-développement, soit en modifiant les conditions d'exposition et/ou de développement de la résine (dose d'insolation, focus, température et durée des recuits post-exposition) d'une façon connue par l'homme du métier. Une telle section transversale de l'évent peut également être obtenue lors de la gravure sèche de l'évent en ajoutant une composante isotrope à la gravure par exemple en ajoutant de l'oxygène dans la chimie utilisée pour graver l'évent. Dans le cas où la couche mince d'encapsulation 6 est constituée de silicium, l'ajout de gaz fluorés dans la chimie de gravure tels que $SF_6$ ou $CF_4$ contribuera également à accroître la composante isotrope de la gravure.

L'effet bénéfique de ce profil particulier de l'évent se manifeste notamment lorsque l'angle $\beta$ que fait le profil de l'évent avec la normale au substrat est supérieur à l'angle $\alpha$ défini précédemment. A titre d'exemple, pour une épaisseur de couche mince d'encapsulation de 800nm et pour une largeur $X_{inf}$ de l'orifice inférieur de 100nm, la largeur $X_{sup}$ de l'orifice supérieur peut être supérieure à 530nm ($\beta$=15°), voire supérieure à 680nm ($\beta$=20°).

Dans le mode de réalisation de la figure 12, l'évent 8 est disposé en bordure de la cavité 4 mais il peut être situé à d'autres endroits de la cavité.

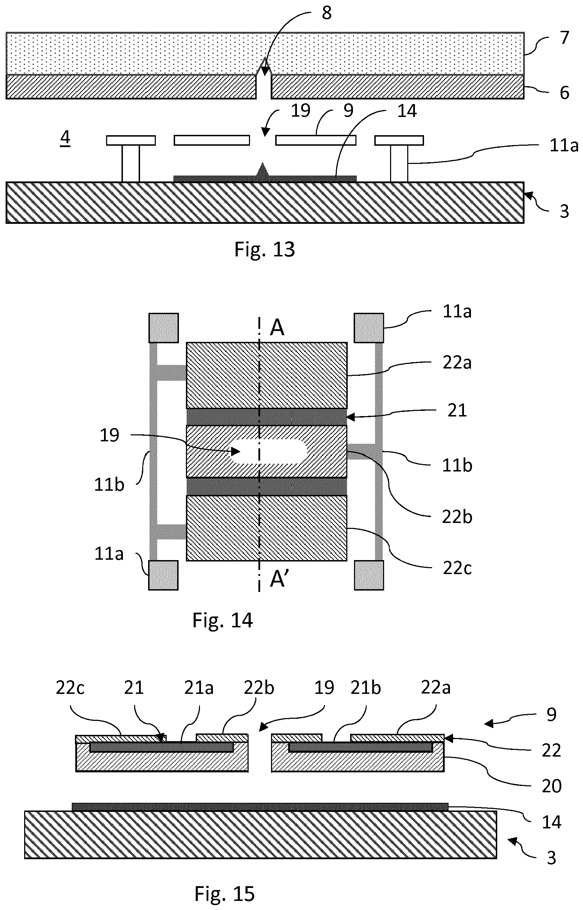

A ce titre, selon un mode de réalisation illustré sur la figure 13, la couche mince d'encapsulation 6 comporte au moins un évent de libération 8 disposé de sorte qu'au moins un détecteur thermique 2 présent dans la cavité 4 ait un unique évent de libération 8 situé en regard de sa membrane absorbante 9, de préférence au droit du centre de la membrane absorbante 9. En d'autres termes, l'unique évent 8 est situé au droit de la membrane absorbante 9, c'est-à-dire à la perpendiculaire de la membrane absorbante 9. L'unique évent 8 n'est donc pas situé en regard des clous d'ancrage 11a ni des bras d'isolation thermique 11b.

Ainsi, la réalisation de l'évent est simplifiée de par son éloignement des zones à forte topographie que sont les tranchées, ce qui permet d'obtenir un bon contrôle dimensionnel de la forme de l'évent. De plus, les inventeurs ont constaté que ce positionnement d'un unique évent en regard de la membrane absorbante du détecteur thermique permet de s'affranchir, après élimination des couches sacrificielles, de la présence de résidus de couches sacrificielles accrochés à la membrane. La présence de ces résidus a notamment été observée lorsqu'au moins deux évents par détecteur sont disposés de part et d'autre de la membrane. Les résidus sont généralement situés dans une zone équidistante des différents évents, dans laquelle se trouve la membrane suspendue. Ils peuvent modifier les propriétés optiques et/ou électriques et/ou thermiques de la membrane (par exemple par augmentation de la masse de la membrane ce qui induit une diminution du temps de réponse du détecteur), voire modifier le niveau de pression résiduelle sous l'effet d'un dégazage progressif. De plus, l'étape d'élimination des couches sacrificielles est optimisée, notamment en termes de durée d'élimination des couches sacrificielles, par un effet conjugué entre la forme oblongue de l'évent et la position centrale de celui-ci vis-à-vis du détecteur.

Dans le cas où la cavité 4 loge un unique détecteur thermique 2, la couche mince d'encapsulation 6 comporte alors un unique évent de libération 8 situé en regard de la membrane absorbante 9 du détecteur thermique. En général, le dispositif de détecteur comporte une matrice de détecteurs thermiques 2 où chaque détecteur est encapsulé dans une unique cavité. La structure d'encapsulation comporte alors une matrice de cavités toutes formées par la même couche mince d'encapsulation. Au niveau de chaque cavité, la couche mince d'encapsulation comporte un unique évent de libération disposé en regard de la membrane absorbante du détecteur logé dans la cavité.

Dans le cas où la cavité 4 loge une pluralité de détecteurs thermiques 2, la couche mince d'encapsulation comporte alors au moins un évent de libération, et de préférence une pluralité d'évents de libération disposés de sorte qu'au moins une partie desdits détecteurs thermiques 2 ait chacun un unique évent de libération 8 situé en regard de la membrane absorbante 9 correspondante. Chaque détecteur thermique de la matrice peut avoir un unique évent disposé en regard de la membrane absorbante correspondante. Alternativement, une partie seulement des détecteurs thermiques peut avoir chacun un unique évent de libération situé en regard de la membrane correspondante. Il est alors avantageux que, pour une ligne ou une colonne de détecteurs thermiques, les évents de libération soient disposés tous les N impair détecteurs. Cela permet d'éviter que des résidus de couches sacrificielles soient présents au niveau de la membrane absorbante d'un détecteur non pourvu d'un évent de libération. A titre d'exemple, dans le cas où N=3, deux détecteurs voisins non pourvus d'évent de libération sont disposés entre deux détecteurs pourvus chacun d'un unique évent de libération. Dans cet exemple, aucun des détecteurs thermiques, qu'ils soient ou non pourvus d'un évent de libération, ne verra sa membrane absorbante dégradée par la présence de résidus de couche sacrificielle. Cette variante de réalisation est particulièrement avantageuse dans le cas des faibles pas de matriçage, par exemple lorsque le pas de disposition des détecteurs est de l'ordre de 12$\mu$m ou moins.

Il est alors avantageux de prévoir un orifice traversant 19 au niveau de la membrane 9 du détecteur, situé au droit de l'évent 8 correspondant, et dont les dimensions sont égales ou supérieures à celles de l'évent 8, moyennant une marge de sécurité pour tenir compte d'un éventuel désalignement de l'évent et/ou de l'orifice de la membrane qui peut être de l'ordre de 200nm à 500nm. Ainsi, lors du dépôt de la couche de scellement, une portion du matériau de scellement susceptible de tomber au travers de l'évent ne viendra pas se déposer sur la membrane mais traversera l'orifice de la membrane et se déposera sur le substrat.

Il est alors avantageux de prévoir (au niveau du substrat) une couche d'accroche, sous la membrane 9, au niveau de l'orifice traversant 19, pour assurer l'accroche de l'agglomérat de scellement qui serait tombé. De manière avantageuse, cette couche d'accroche peut être une portion de la couche d'accroche 14 mentionnée précédemment, dont le matériau est alors adapté à assurer en outre l'accroche du matériau de scellement. Ainsi, lors de l'étape de scellement de la cavité, dans le cas où une quantité de matière de la couche de scellement traverserait l'évent, elle viendrait se déposer et adhérer sur la couche d'accroche. Cela permet notamment de s'affranchir du type de matériau présent en surface du substrat, et plus précisément du matériau utilisé pour passiver la face supérieure du substrat.

Cette couche d'accroche 14, peut s'étendre, de manière continue ou discontinue, au niveau de différentes zones de la cavité, plus précisément sous la membrane 9 et en regard de son orifice traversant 19 pour assurer l'accroche du matériau de scellement susceptible de tomber au travers de l'évent 8 ; sous l'ensemble de la membrane 9 pour assurer une fonction optique de réflexion du rayonnement à détecter; au niveau des différentes tranchées 17, 18 pour la protection du substrat 3 pendant l'étape de gravure lors de la formation des tranchées et pour améliorer l'accroche de la couche mince d'encapsulation 6 sur le substrat ; et au niveau des clous d'ancrage 11a pour améliorer l'accroche des clous sur le substrat et améliorer la conduction électrique entre les clous et le circuit de lecture disposé dans le substrat. L'épaisseur de cette couche d'accroche est de préférence constante sur toute son étendue, et notamment au niveau des différentes zones mentionnées précédemment. Cette couche d'accroche peut être réalisée en chrome ou titane, en aluminium, en nitrure de titane, ou autre matériau adapté, par exemple sous forme d'empilement des matériaux cités, et présenter une épaisseur de l'ordre de 100nm à 400nm.

Selon un mode de réalisation représenté sur les figures 14 et 15, les détecteurs 2 dont la membrane 9 comporte un orifice traversant 19 présentent une architecture de membrane à isolation électrique intermédiaire, telle que décrite dans le document EP1067372.

La figure 14 est une vue de dessus d'une membrane absorbante 9 d'un détecteur bolométrique selon ce type d'architecture. Elle est reliée à quatre clous d'ancrage 11a et est suspendue par le biais de deux bras d'isolation thermique 11b. La figure 15 est une vue en coupe selon le plan A-A de la figure 14.

La membrane 9 comporte une couche d'un matériau bolométrique 20 (donc résistif), par exemple du silicium amorphe dopé ou de l'oxyde de vanadium. Elle comporte également une couche d'un matériau diélectrique 21, déposée sur la couche bolométrique 20 et qui recouvre celle-ci sur deux zones distinctes 21a, 21b.

Elle comporte également une couche d'un matériau électriquement conducteur 22, déposée sur la couche diélectrique 21 et la couche bolométrique 20 et gravée localement sur toute la largeur de la membrane jusqu'à la couche diélectrique de manière à former trois portions conductrices distinctes 22a, 22b, 22c. La couche conductrice 22 se prolonge sur les bras d'isolation 11b pour relier électriquement les trois portions 22a, 22b, 22c au circuit de lecture. Parmi les trois portions conductrices, deux portions 22a, 22c situées aux extrémités de la membrane 9 sont électriquement reliées à deux parties d'un même bras d'isolation 11b et forment ainsi deux électrodes destinées à être portées à un même potentiel électrique. Ces deux portions d'extrémités 22a, 22c encadrent une portion centrale 22b reliée à un autre bras d'isolation qui forme une électrode destinée à être portée à un autre potentiel électrique.

La couche diélectrique 21 est gravée de sorte que chaque électrode 22a, 22b, 22c est en contact électrique avec le matériau bolométrique 20 et que les électrodes d'extrémités 22a, 22c sont électriquement isolées de l'électrode centrale 22b.

Dans ce mode de réalisation, la membrane absorbante 9 comporte un orifice traversant 19, ici de profil oblong, disposé au centre de l'électrode centrale 22b. De préférence, l'orifice 19 est disposé au niveau où la couche diélectrique 21 est gravée. L'orifice 19 traverse ainsi uniquement l'électrode centrale 22b et la couche bolométrique 20. De préférence, la distance, mesurée dans le sens de la largeur de l'orifice 19, entre la bordure de l'orifice et la bordure de la couche diélectrique 21, en regard de l'orifice, est supérieure ou égale à l'épaisseur de la couche bolométrique 20 en contact avec l'électrode centrale 22b dans cette zone. Par ce positionnement de l'orifice, toute influence de celui-ci sur les propriétés électriques de la membrane absorbante est minimisée voire supprimée.

L'exemple décrit en référence aux figures 14 et 15 montre une couche bolométrique 20 dans la partie inférieure de la membrane 9, sur laquelle reposent la couche diélectrique 21 et les électrodes 22a, 22b, 22c. Cependant, un agencement inversé des couches est également réalisable, dans lequel les électrodes 22a, 22b, 22c sont situées dans la partie inférieure de la membrane 9, sur lesquelles reposent la couche diélectrique 21 puis la couche bolométrique 20.

## Revendications

1. Dispositif de détection (1) de rayonnement électromagnétique, comprenant :

   - un substrat (3),
   - au moins un détecteur thermique (2), disposé sur le substrat (3),
   - une structure d'encapsulation (5) du détecteur thermique (2), comportant une couche mince d'encapsulation (6) s'étendant autour et au-dessus du détecteur (2) de manière à définir avec le substrat (3) une cavité (4) dans laquelle le détecteur thermique (2) est situé, ladite couche mince d'encapsulation étant réalisé en un matériau transparent audit rayonnement électromagnétique, la couche mince d'encapsulation (6) comprenant une paroi périphérique (6a) qui entoure le détecteur thermique (2), et qui présente une section, dans un plan parallèle au plan du substrat, de forme carrée ou rectangulaire, dont les coins (6a-3) sont arrondis,
   **caractérisé en ce que** la paroi périphérique (6a) comporte une portion arrondie (6a-3) et deux portions (6a-1, 6a-2) rectilignes s'étendant suivant des axes (X1, X2) sensiblement orthogonaux l'un à l'autre et reliées l'un à l'autre par la portion arrondie, la portion arrondie présentant un rayon de courbure supérieur ou égal à deux fois l'épaisseur de l'une des portions rectilignes (6a-1, 6a-2).

2. Dispositif de détection selon la revendication 1, dans lequel le rayon de courbure de la portion arrondie (6a-3) est mesuré à partir de la surface interne, orientée vers la cavité, de la portion arrondie.

3. Dispositif de détection selon l'une quelconque des revendications 1 à 2, dans lequel la couche mince d'encapsulation (6) comporte au moins un orifice traversant (8), dit évent de libération, ladite structure d'encapsulation (5) comporte en outre une couche de scellement (7) recouvrant la couche mince d'encapsulation (6) de manière à rendre la cavité (4) hermétique.

4. Dispositif de détection selon l'une quelconque des revendications 1 à 3, le dispositif comportant une matrice de détecteurs (2) disposés dans une même cavité, dans lequel la couche mince d'encapsulation (6) comprend en outre au moins une portion (12), dite portion d'appui interne, située entre deux détecteurs (2) adjacents, qui prend appui directement sur le substrat (3).

5. Dispositif de détection selon la revendication 4, dans lequel la portion d'appui interne (12) présente un profil, dans un plan parallèle au plan du substrat (3), de forme oblongue, de préférence aux extrémités longitudinales arrondies.

6. Dispositif de détection selon la revendication 4 ou 5, dans lequel la portion d'appui interne (12) comporte une paroi latérale (12a) et une partie inférieure (12b), ladite paroi latérale (12a) s'étendant de manière sensiblement verticale sur toute la hauteur de la cavité (4) et la partie inférieure (12b) étant au contact du substrat (3).

7. Dispositif de détection selon l'une quelconque des revendications 1 à 6, comportant une matrice de détecteurs thermiques (2) comportant chacun une membrane (9) adaptée à absorber le rayonnement à détecter, suspendue au-dessus du substrat (3) et isolée thermiquement de celui-ci par des clous d'ancrage (11a) et des bras d'isolation thermique (11b), la couche mince d'encapsulation (6) comportant une pluralité d'orifices traversants (8) dit évents de libération disposés de sorte qu'au moins une partie desdits détecteurs thermiques (2) ait chacun un unique évent de libération (8) situé en regard de la membrane absorbante (9) correspondante, de préférence au droit du centre de ladite membrane (9).

8. Dispositif de détection selon la revendication 7, dans lequel ladite membrane absorbante (9), en regard de laquelle est située un évent de libération (8), comporte un orifice traversant (19), situé au droit dudit évent de libération (8), de dimensions égales ou supérieures à celles dudit évent (8).

9. Dispositif de détection selon la revendication 8, dans lequel la membrane suspendue comporte un empilement d'une couche bolométrique (20), d'une couche diélectrique (21) structurée de manière à former deux portions distinctes (21a, 21b), et d'une couche électriquement conductrice (22) structurée de manière à former trois électrodes (22a, 22b, 22c), dont deux électrodes (22a, 22c) destinées à être portées à une même potentiel électrique encadrent la troisième électrode (22b) dite centrale destinée à être portée à un potentiel électrique différent, chaque électrode étant au contact de la couche bolométrique (20), l'électrode centrale (22b) étant électriquement isolée des autres électrodes (22a, 22c) par la couche diélectrique (21), l'orifice (19) traversant l'électrode centrale (22b) et la couche bolométrique (20) dans une zone située entre les portions (21a, 21b) de la couche diélectrique (21).

10. Dispositif de détection selon la revendication 8 ou 9, dans lequel la structure d'encapsulation (5) comporte en outre une couche de scellement (7) recouvrant la couche mince d'encapsulation (6) de manière à rendre la cavité (4) hermétique, et dans lequel le substrat (3) comprend une couche d'accroche (14) disposée en regard de l'orifice traversant (19) de la membrane (9) correspondante, et adaptée à assurer l'adhésion du matériau de la couche de scellement (7).

11. Dispositif de détection selon la revendication 10, dans lequel la couche d'accroche (14) s'étend sous l'ensemble de la membrane (9) correspondante et est réalisée en un matériau adapté pour assurer en outre la réflexion du rayonnement électromagnétique à détecter.

12. Procédé de réalisation d'un dispositif de détection selon l'une quelconque des revendications 1 à 11 dans lequel la couche mince d'encapsulation (6) est déposée sur une couche sacrificielle, cette dernière étant ensuite supprimée et évacuée au travers d'au moins un évent de libération (8) de la couche mince d'encapsulation (6).

**Patentansprüche**

1. Erfassungsvorrichtung (1) zur Erfassung elektromagnetischer Strahlung, umfassend:

- ein Substrat (3),
- mindestens einen auf dem Substrat (3) angeordneten Wärmedetektor (2),
- eine Einkapselungsstruktur (5) zur Einkapselung des Wärmedetektors (2), die eine dünne Einkapselungsschicht (6) beinhaltet, die sich um den und über dem Detektor (2) erstreckt, so dass sie mit dem Substrat (3) einen Hohlraum (4) definiert, in dem der Wärmedetektor (2) gelegen ist, wobei die dünne Einkapselungsschicht aus einem für die elektromagnetische Strahlung durchlässigen Material ausgeführt ist, wobei die dünne Einkapselungsschicht (6) eine Umfangswand (6a) umfasst, die den Wärmedetektor (2) umschließt und die in einer Ebene parallel zur Ebene des Substrats einen Querschnitt von quadratischer oder rechteckiger Form aufweist, dessen Ecken (6a-3) gerundet sind, **dadurch gekennzeichnet, dass** die Umfangswand (6a) einen gerundeten Abschnitt (6a-3) umfasst und zwei geradlinige Abschnitte (6a-1, 6a-2), die sich entlang von Achsen (X1, X2) erstrecken, die im Wesentlichen senkrecht zueinander verlaufen und durch den gerundeten Abschnitt miteinander verbunden sind, wobei der gerundete Abschnitt einen Krümmungsradius aufweist, der größer oder gleich dem Zweifachen der Dicke des einen der geradlinigen Abschnitte (6a-1, 6a-2) ist.

2. Erfassungsvorrichtung nach Anspruch 1, bei welcher der Krümmungsradius des gerundeten Abschnitts (6a-3) ausgehend von der zum Hohlraum gewandten inneren Fläche des gerundeten Abschnitts gemessen wird.

3. Erfassungsvorrichtung nach einem der Ansprüche 1 bis 2, bei der die dünne Einkapselungsschicht (6) mindestens eine durchgehende Öffnung (8), Entlastungsöffnung genannt, beinhaltet, wobei die Einkapselungsstruktur (5) ferner eine Versiegelungsschicht (7) beinhaltet, welche die dünne Einkapselungsschicht (6) überzieht, so dass der Hohlraum (4) hermetisch gemacht wird.

4. Erfassungsvorrichtung nach einem der Ansprüche 1 bis 3, wobei die Vorrichtung eine Matrix aus Detektoren (2) beinhaltet, die in demselben Hohlraum angeordnet sind, wobei die dünne Einkapselungsschicht (6) ferner mindestens einen zwischen zwei benachbarten Detektoren (2) gelegenen Abschnitt (12), innerer Stützabschnitt genannt, umfasst, der sich direkt auf dem Substrat (3) abstützt.

5. Erfassungsvorrichtung nach Anspruch 4, wobei der innere Stützabschnitt (12) in einer Ebene parallel zur Ebene des Substrats (3) ein längliches Profil aufweist, bevorzugt mit gerundeten Längsenden.

6. Erfassungsvorrichtung nach Anspruch 4 oder 5, bei welcher der innere Stützabschnitt (12) eine Seitenwand (12a) und einen unteren Teil (12b) beinhaltet, wobei sich die Seitenwand (12a) im Wesentlichen vertikal über die gesamte Höhe des Hohlraums (4) erstreckt und der untere Teil (12b) in Kontakt mit dem Substrat (3) ist.

7. Erfassungsvorrichtung nach einem der Ansprüche 1 bis 6, beinhaltend eine Matrix aus Wärmedetektoren (2), die jeweils eine Membran (9) beinhalten, die geeignet ist, die zu erfassende Strahlung zu absorbieren, über dem Substrat (3) aufgehängt ist und von diesem thermisch durch Verankerungsnägel (11a) und Wärmeisolationsarme (11b) isoliert ist, wobei die dünne Einkapselungsschicht (6) eine Mehrzahl von durchgehenden Öffnungen (8), Entlastungsöffnungen genannt, beinhaltet, die derart angeordnet sind, dass mindestens ein Teil der Wärmedetektoren (2) jeweils eine einzige Entlastungsöffnung (8) hat, die gegenüber der entsprechenden absorbierenden Membran (9) gelegen ist, bevorzugt lotrecht zum Mittelpunkt der Membran (9).

8. Erfassungsvorrichtung nach Anspruch 7, bei der die absorbierende Membran (9), gegenüber der eine Entlastungsöffnung (8) gelegen ist, eine durchgehende Öffnung (19) beinhaltet, die lotrecht zur Entlastungsöffnung (8) gelegen ist und die gleichen oder größere Abmessungen wie die Entlastungsöffnung (8) hat.

9. Erfassungsvorrichtung nach Anspruch 8, bei der die aufgehängte Membran einen Stapel beinhaltet aus einer bolometrischen Schicht (20), aus einer dielektrischen Schicht (21), die so strukturiert ist, dass sie zwei getrennte Abschnitte (21a, 21b) bildet, und aus einer elektrisch leitfähigen Schicht (22), die so strukturiert ist, dass sie drei Elektroden (22a, 22b, 22c) bildet, von denen zwei Elektroden (22a, 22c), die dazu bestimmt sind, auf das gleich elektrische Potential gebracht zu werden, die dritte Elektrode (22b), mittlere genannt, einrahmen, die dazu bestimmt ist, auf ein unterschiedliches elektrisches Potential gebracht zu werden, wobei jede Elektrode mit der bolometrischen Schicht (20) in Kontakt ist, wobei die mittlere Elektrode (22b) von den anderen Elektroden (22a, 22c) durch die dielektrische Schicht (21) elektrisch isoliert ist, wobei die Öffnung (19) die mittlere Elektrode (22b) und die bolometrische Schicht (20) in einem Bereich durchdringt, der zwischen den Abschnitten (21a, 21b) der dielektrischen Schicht (21) gelegen ist.

10. Erfassungsvorrichtung nach Anspruch 8 oder 9, bei der die Einkapselungsstruktur (5) ferner eine Versiegelungsschicht (7) beinhaltet, welche die dünne Einkapselungsschicht (6) so überzieht, dass der Hohlraum (4) hermetisch gemacht wird, und bei der das Substrat (3) eine Haftgrundschicht (14) umfasst, die gegenüber der durchgehenden Öffnung (19) der entsprechenden Membran (9) angeordnet ist und geeignet ist, das Haften des Materials der Versiegelungsschicht (7) zu gewährleisten.

11. Erfassungsvorrichtung nach Anspruch 10, bei der sich die Haftgrundschicht (14) unter der Gesamtheit der entsprechenden Membran (9) erstreckt und aus einem Material ausgeführt ist, das geeignet ist, ferner die Reflexion der zu erfassenden elektromagnetischen Strahlung zu gewährleisten.

12. Verfahren zur Ausführung einer Erfassungsvorrichtung nach einem der Ansprüche 1 bis 11, bei dem die dünne Einkapslungsschicht (6) auf einer Opferschicht abgeschieden wird, wobei Letztere anschließend beseitigt und durch mindestens eine Entlastungsöffnung (8) der dünnen Einkapselungsschicht (6) abgeführt wird.

**Claims**

1. Device (1) for detecting electromagnetic radiation, comprising:

    - a substrate (3);
    - at least one thermal detector (2), placed on the substrate (3); and
    - an encapsulating structure (5) encapsulating the thermal detector (2), including a thin encapsulating layer (6) extending around and above the detector (2) so as to define with the substrate (3) a cavity (4) in which the thermal detector (2) is located, said thin encapsulating layer being produced from a material that is transparent to said electromagnetic radiation, the thin encapsulating layer (6) comprising a peripheral wall (6a) that encircles the thermal detector (2), and that has a cross section, in a plane parallel to the plane of the substrate, of square or rectangular shape, the corners (6a-3) of which are rounded;

    **characterized in that** the peripheral wall (6a) includes a rounded section (6a-3) and two rectilinear sections (6a-1, 6a-2) extending along axes (X1, X2) that are substantially orthogonal to each other, said rectilinear sections being connected to each other by the rounded section, the rounded section having a radius of curvature larger than or equal to two times the thickness of one of the rectilinear sections (6a-1, 6a-2).

2. Detecting device according to Claim 1, in which the radius of curvature of the rounded section (6a-3) is measured from the internal surface, i.e. that oriented towards the cavity, of the rounded section.

3. Detecting device according to either one of Claims 1 and 2, in which the thin encapsulating layer (6) includes at least one through-orifice (8) that is what is referred to as an exhaust vent, said encapsulating structure (5) furthermore including a sealing layer (7) covering the thin encapsulating layer (6) so as to make the cavity (4) hermetic.

4. Detecting device according to any one of Claims 1 to 3, the device including a matrix of detectors (2) placed in one and the same cavity, in which the thin encapsulating layer (6) furthermore comprises at least one section (12), which is what is referred to as an internal bearing section, located between two adjacent detectors (2), and which bears directly against the substrate (3).

5. Detecting device according to Claim 4, in which the internal bearing section (12) has a profile, in a plane parallel to the plane of the substrate (3) of oblong shape, preferably with rounded longitudinal ends.

6. Detecting device according to Claim 4 or 5, in which the internal bearing section (12) includes a sidewall (12a) and a bottom portion (12b), said sidewall (12a) extending substantially vertically over the entire height of the cavity (4) and the bottom portion (12b) making contact with the substrate (3).

7. Detecting device according to any one of Claims 1 to 6, including a matrix of thermal detectors (2), each detector including a membrane (9) suitable for absorbing the radiation to be detected, which membrane is suspended above the substrate (3) and thermally insulated therefrom by anchoring pins (11a) and thermally insulating arms (11b), the thin encapsulating layer (6) including a plurality of through-orifices (8) that are what are referred to as exhaust vents placed so that at least some of said thermal detectors (2) each have a single exhaust vent (8) located facing the corresponding absorbing membrane (9), preferably plumb with the centre of said membrane (9).

8. Detecting device according to Claim 7, in which said absorbing membrane (9), facing which is located an exhaust vent (8), includes a through-orifice (19) located plumb with said exhaust vent (8) and of larger or equal size to that of said vent (8).

9. Detecting device according to Claim 8, in which the suspended membrane includes a stack of a bolometric layer (20), a dielectric layer (21) that is structured so as to form two separate sections (21a, 21b), and an electrically conductive layer (22) that is structured so as to form three electrodes (22a, 22b, 22c), two of said electrodes (22a, 22c), which are intended to be raised to the same electrical potential, flanking the third electrode (22b), which is what is referred to as the central electrode and which is intended to be raised to a different electrical potential, each electrode making contact with the bolometric layer (20), the central electrode (22b) being electrically insulated from the other electrodes (22a, 22c) by the dielectric layer (21), the through-orifice (19) passing through the central electrode (22b) and the bolometric layer (20) in a zone located between the sections (21a, 21b) of the dielectric layer (21).

10. Detecting device according to Claim 8 or 9, in which the encapsulating structure (5) furthermore includes a sealing layer (7) covering the thin encapsulating layer (6) so as to make the cavity (4) hermetic, and in which the substrate (3) comprises a tie layer (14) placed facing the through-orifice (19) of the corresponding membrane (9) and suitable for ensuring the adhesion of the material of the sealing layer (7).

11. Detecting device according to Claim 10, in which the tie layer (14) extends under the whole of the corresponding membrane (9) and is furthermore made of a material suitable for reflecting the electromagnetic radiation to be detected.

12. Process for producing a detecting device according to any one of Claims 1 to 11, in which the thin encapsulating layer (6) is placed on a sacrificial layer, the latter then being removed and extracted through at least one exhaust vent (8) in the thin encapsulating layer (6).

Fig.1

Fig.2

6    6a    6a-1

X2

6a-3

r

6a-2

L

Fig. 3

X1

6    6a    6a-1

X2

6a-3

r

6a-2

L

Fig. 4

X1

Fig. 5

Fig. 6

Fig. 7

Fig. 8

Fig. 9

Fig. 10

Fig. 11

Fig. 12

Fig. 13

Fig. 14

Fig. 15

**EP 3 067 676 B1**

## RÉFÉRENCES CITÉES DANS LA DESCRIPTION

**Documents brevets cités dans la description**

- EP 1106980 A
- EP 1359400 A
- EP 1067372 A

**Littérature non-brevet citée dans la description**

- **DUMONT et al.** Current progress on pixel level packaging for uncooled IRFPA. *Proc. SPIE 8353, Infrared Technology and Applications XXXVIII,* 2012, 835311